# EUROPÄISCHE PATENTSCHRIFT

(11) **EP 1 681 768 B1**
(45) Veröffentlichungstag und Bekanntmachung des Hinweises auf die Patenterteilung: **27.02.2008**
(21) Anmeldenummer: 05027119.6
(22) Anmeldetag: 12.12.2005
(51) Int. Cl.: H03L 3/00, H03B 5/06

(54) **Schnellstartschaltung für Quarz-Oszillatoren**
Circuit for fast start-up of a crystal oscillator
Circuit pour le démarrage rapide d'un oscillateur à quartz

(30) Priorität: 13.01.2005 DE 102005001684
(43) Veröffentlichungstag der Anmeldung: 19.07.2006
(73) Patentinhaber: Infineon Technologies AG, 81669 München (DE)
(72) Erfinder: Christ, Volker, 41470 Neuss (DE)
(74) Vertreter: Patentanwälte Lambsdorff & Lange

(56) Entgegenhaltungen:
- EP-A- 0 709 965
- US-A- 6 057 742
- US-A1- 2002 171 500

## Beschreibung

Die Erfindung betrifft ein Verfahren und eine Vorrichtung zur Unterstützung des Anschwingvorgangs von elektro-mechanischen Oszillatoren, insbesondere Quarz-Oszillatoren. Die US 6 057 742 zeigt einen Oszillator mit Anschwingunterstützung gemäß dem Oberbegriff von Anspruch 1.

Zum Datenaustausch zwischen verschiedenen Kommunikations-Endgeräten wird in den Teilnehmergeräten zum Senden und Empfangen von Daten ein identisches Takt- bzw. Oszillatorsignal benötigt. Bei einem Datenaustausch über Funkstrecken handelt es sich dabei meist um ein hochfrequentes Takt- bzw. Oszillatorsignal (z.B. bei 2 GHz oder darüber). Dieses Takt- bzw. Oszillatorsignal muss in den verschiedenen Kommunikations-Endgeräten unabhängig voneinander erzeugt werden, weswegen die einzelnen Taktsignale zur Erhaltung der Synchronität zwischen den Teilnehmergeräten eine hohe Frequenzstabilität aufweisen müssen. Zur Erzeugung des frequenzstabilen Takt- bzw. Oszillatorsignals werden daher in der Regel elektro-mechanische Oszillatoren, wie Schwingquarze oder ähnliche piezo-elektrische Oszillatoren, herangezogen.

Quarz-Oszillatoren weisen eine hohe Leistungsaufnahme auf, was vor allem in Netz-unabhängigen bzw. Batterie-betriebenen Endgeräten, wie beispielsweise Mobiltelefonen, nachteilig ist, da der relativ hohe Energieverbrauch die Betriebszeit solcher Netz-unabhängigen Endgeräte verkürzt. Die frequenzgebenden Schwingquarze werden daher in der Regel nicht permanent betrieben, sondern lediglich zu solchen Zeiten, bei welchen ein tatsächlicher Datenaustausch stattfindet bzw. möglich sein soll.

Sofern lediglich die Möglichkeit eines Datenaustausches gewährleistet werden soll (z.B. während des Bereitschaftsmodus von Mobiltelefonen), so wird das Teilnehmergerät meist in regelmäßigen Abständen kurzzeitig auf Empfang geschaltet, wozu das hochfrequente Taktsignal benötigt wird. Folglich wird der Quarz-Oszillator in regelmäßigen Abständen ebenfalls kurzzeitig angeschaltet. Das hochfrequente Taktsignal wird dabei in der Regel nur für wenige Millisekunden benötigt. Allerdings muss beachtet werden, dass auch der Quarz-Oszillator selbst eine Anschwingdauer von mehreren Millisekunden besitzt.

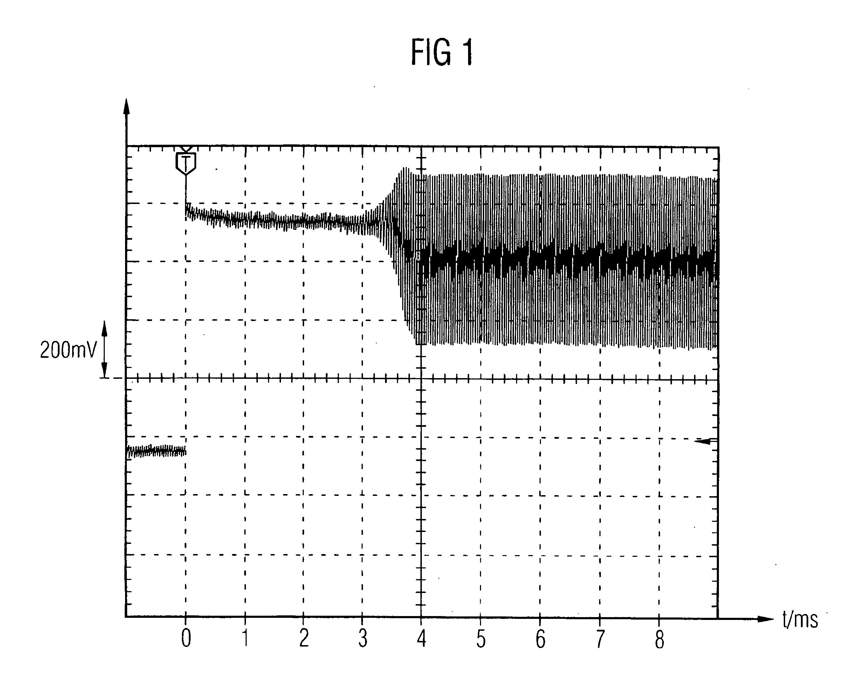

In Fig. 1 ist der gemessene Anschwingvorgang eines bekannten Quarz-Oszillators dargestellt. Die Versorgungsspannung wird bei t = 0 eingeschaltet und der Schwingquarz ist nach ca. 4 ms stabil eingeschwungen. Das hochfrequente Taktsignal steht somit erst mehrere Millisekunden nach dem Einschalten des Schwingquarzes zur Verfügung. Wird das hochfrequente Taktsignal ebenfalls nur für wenige Millisekunden benötigt, so verlängert der Anschwingvorgang des Quarz-Oszillators, während welchem das hochfrequente Taktsignal noch nicht zur Verfügung steht, dessen Gesamt-Betriebsdauer signifikant. Die Gesamt-Betriebsdauer und somit der Energieverbrauch des Quarz-Oszillators wird bei einem solchen kurzzeitigem Betrieb erheblich von der Dauer des Anschwingvorgangs bestimmt.

Aufgabe der Erfindung ist daher, ein Verfahren und eine Vorrichtung zur Unterstützung bzw. Beschleunigung des Anschwingvorgangs von Quarz-Oszillatoren anzugeben. Es ist weiterhin Aufgabe der Erfindung, eine Oszillator-Schaltung mit einer Vorrichtung zur Unterstützung des Anschwingvorgangs anzugeben.

Diese Aufgabe wird durch die Merkmale der unabhängigen Ansprüche gelöst. Vorteilhafte Ausgestaltungen und Weiterbildungen der Erfindung sind in den Unteransprüchen angegeben.

Das erfindungsgemäße Verfahren zum Beschleunigen bzw. Unterstützen des Anschwingvorgangs eines elektro-mechanischen Oszillators umfasst ein Rückkoppel-Verfahren. In dem Rückkoppel-Verfahren werden in einem ersten Schritt Spannungsvariationen und Oszillatorschwingungen, welche in dem Ausgangssignal des elektro-mechanischen Oszillators auftreten, detektiert. In einem zweiten Schritt wird anhand einer detektierten Oszillatorschwingung ein Anregungspuls generiert und dieser in einem dritten Schritt in den elektro-mechanischen Oszillator eingespeist.

Unmittelbar nach dem Einschalten der Versorgungsspannung des Quarz-Oszillators ist dieser noch nicht eingeschwungen, gibt jedoch ein Ausgangssignal mit Spannungsvariationen entsprechend dem Eigenrauschen des Schwingquarzes mit darin enthaltenen Rauscheffekten und ersten Oszillationen ab. Diese Spannungsvariationen werden im ersten Schritt des erfindungsgemäßen Rückkoppel-Verfahrens detektiert. Anhand einer detektierten Spannungsvariation wird ein Anregungspuls erzeugt und an den elektro-mechanischen Oszillator abgegeben. Die Zeit, die vom Detektieren einer Spannungsvariation bis zum Einspeisen des daraus erzeugten Anregungspulses vergeht, ist im Allgemeinen vernachlässigbar gegenüber der Schwingungsdauer des elektro-mechanischen Oszillators. Die Anregungspulse werden somit auf der Zeitskala der Oszillatorschwingung instantan nach der Detektion einer Spannungsvariation bzw. einer Oszillatorschwingung im Ausgangssignal des elektro-mechanischen Oszillators in den elektro-mechanischen Oszillator eingespeist. Die im ersten Schritt des Rückkoppel-Verfahrens detektierte Spannungsvariation wird somit phasenrichtig verstärkt. Sobald in dem Ausgangssignal des elektro-mechanischen Oszillators Spannungsvariationen detektierbar sind, werden diese bzw. die zu Grunde liegenden mechanischen Schwingungen des elektro-mechanischen Oszillators gezielt verstärkt, indem durch die instantan generierten und eingespeisten Anregungspulse zusätzliche Ladungen in den elektro-mechanischen Oszillator getrieben werden. Die Schwingungsamplitude der Spannungsvariation bzw. der Oszillatorschwingung des elektro-mechanischen Oszillators erhöht sich dadurch.

Durch das erfindungsgemäße Verfahren werden Rauscheffekte und erste Oszillationen des elektro-mechanische Oszillators gezielt verstärkt und die Oszillations-Amplitude des elektro-mechanischen Oszillators nimmt deutlich schneller zu als bei bekannten Verfahren zum Einschalten eines elektro-mechanischen Oszillators. Dadurch wird die volle Schwingungs-Amplitude des elektro-mechanischen Oszillators, d.h. der eingeschwungene Zustand, deutlich schneller erreicht und der Anschwingvorgang dadurch signifikant verkürzt. Das nutzbare hochfrequente Takt- bzw. Oszillatorsignal steht somit wesentlich schneller nach dem Anschalten des elektro-mechanischen Oszillators zur Verfügung und die Zeit, in welcher der elektro-mechanische Oszillator zwar Leistung aufnimmt ,jedoch kein nutzbares hochfrequentes Taktsignal abgibt, wird reduziert. Der elektro-mechanische Oszillator wird dadurch wesentlich energiesparender betrieben, da die Gesamt-Betriebsdauer des elektro-mechanischen Oszillators sinkt. Durch das erfindungsgemäße Verfahren verlängert sich die mögliche Betriebszeit von Netz-unabhängigen Kommunikations-Endgeräten.

In einer vorteilhaften Ausgestaltung des erfindungsgemäßen Verfahrens umfasst das Detektieren der Spannungsvariation bzw. der Oszillatorschwingungen in dem Ausgangssignal des elektro-mechanischen Oszillators das Verstärken von in dem Ausgangssignal des elektro-mechanischen Oszillators auftretenden Oszillatorschwingungen und das Erzeugen eines Taktsignals anhand der verstärkten Oszillatorschwingungen. Das Taktsignal kann dabei ein analoges als auch ein digitales Taktsignal sein. Aus dem Rauschen und den Anfangsschwingungen des elektro-mechanischen Oszillators wird somit ein (zunächst unregelmäßiges) Taktsignal geformt, aus welchem im weiteren Verlauf Anregungspulse zur Einspeisung in den elektro-mechanischen Oszillator generiert werden.

In einer weiteren vorteilhaften Ausgestaltung des erfindungsgemäßen Verfahrens werden die Anregungspulse in Abhängigkeit eines Freigabesignals erzeugt. Das Freigabesignal bestimmt, ob anhand einer detektierten Oszillatorschwingung ein Anregungspuls generiert und anschließend in den elektro-mechanischen Oszillator eingespeist wird, und gibt somit die Zeitpunkte vor, zu welchen die Generierung und Einspeisung eines oder mehrerer Anregungspulse veranlasst wird.

In einer bevorzugten Ausgestaltung wird das Freigabesignal mit Hilfe des von der Detektionseinheit abgegebenen Taktsignals erzeugt. Durch die Kopplung des Freigabesignals an das Taktsignal wird das Freigabesignal an das möglicherweise noch unregelmäßige Taktsignal bzw. an die bereits vorhandenen Oszillatorschwingungen angepasst.

In einer weiteren vorteilhaften Ausgestaltung des erfindungsgemäßen Verfahrens wird das Rückkoppel-Verfahren mehrfach ausgeführt. Dadurch wird eine Mehrzahl von Anregungspulsen erzeugt und in den elektro-mechanischen Oszillator eingespeist. Die Generierung der Mehrzahl von Anregungspulsen geschieht anhand einer Mehrzahl von in dem Ausgangssignal des elektro-mechanischen Oszillators detektierten Spannungsvariationen bzw. auftretenden Oszillatorschwingungen bzw. anhand des daraus abgeleiteten Taktsignals. Die Anregungspulse können anhand aufeinander folgender Taktsignale bzw. Oszillatorschwingungen im Ausgangssignal des elektro-mechanischen Oszillators generiert werden oder auch anhand von nicht aufeinander folgenden Taktsignalen, sodass nicht auf Grund jeder detektierten Spannungsvariation bzw. Oszillatorschwingung ein Anregungspuls in den elektro-mechanischen Oszillator eingespeist wird. Zwischen derart beabstandeten, aufeinander folgenden Anregungspulsen entstehen somit Lücken bzw. Pausen, welche eine oder mehrere detektierte Oszillatorschwingungen überspannen. Vorteilhafterweise wird das Freigabesignal zur Steuerung der Erzeugung der Anregungspulse herangezogen.

Das Einspeisen eines Anregungspulses in den elektro-mechanischen Oszillator regt jedoch nicht nur die beabsichtigte Schwingungsfrequenz an, sondern auch Oberschwingungen und andere unerwünschte Schwingungen. Das Einfügen von Pausen bzw. Lücken zwischen aufeinander folgenden Anregungspulsen lässt die ungewollten Oberschwingungen abklingen und trägt somit dazu bei, dass der elektro-mechanische Oszillator lediglich auf der beabsichtigten Oszillatorfrequenz schwingt. Das mehrfache Ausführen des erfindungsgemäßen Rückkoppel-Verfahrens verstärkt die Schwingungsamplitude des elektro-mechanischen Oszillators zusätzlich und liefert demnach einen Beitrag dazu, dass die Anschwingzeit weiter verringert wird.

In einer weiteren bevorzugten Ausgestaltung des erfindungsgemäßen Verfahrens werden Gruppen von Anregungspulsen mit einer vorgegebenen Anzahl von Anregungspulsen erzeugt und in den elektro-mechanischen Oszillator eingespeist. Die Gruppen umfassen mindestens einen Anregungspuls. Umfassen die Gruppen jeweils eine Mehrzahl von Anregungspulsen, so werden die Anregungspulse der Gruppe anhand von aufeinander folgenden detektierten Oszillatorschwingungen oder anhand von beabstandeten, nicht aufeinander folgenden detektierten Oszillatorschwingungen bzw. Taktsignalen erzeugt. Eine Gruppe ist von der vorhergehenden und der nachfolgenden Gruppe durch eine Anzahl von detektierten Oszillatorschwingungen bzw. Taktsignalen, anhand derer kein Anregungspuls generiert und eingespeist wird, beabstandet. In einer besonders bevorzugten Ausgestaltung weisen die aufeinander folgenden Gruppen von Anregungspulsen eine identische Struktur auf und sind durch eine identische Anzahl von detektierten Oszillatorschwingungen getrennt bzw. beabstandet, sodass eine periodische Gruppenstruktur von Anregungspulsen entsteht.

In einer weiteren bevorzugten Ausgestaltung des erfindungsgemäßen Verfahrens werden in dem Ausgangssignal des elektromagnetischen Oszillators nur solche Spannungsvariationen bzw. darin auftretende Oszillatorschwingungen detektiert bzw. verstärkt, welche einen vorgegebenen Schwellwert übersteigen. Dieser Schwellwert wird beispielsweise so eingestellt, dass die detektierten Spannungsvariationen bzw. Oszillatorschwingungen, anhand welcher das Taktsignal generiert wird, mit einer gewissen Sicherheit nicht mehr dem (statistischen) Eigenrauschen des elektro-mechanischen Oszillators zuzurechnen sind. Dieser Schwellwert kann beispielsweise im Bereich zwischen 2 und 10 mV liegen.

In einer weiteren bevorzugten Ausgestaltung des erfindungsgemäßen Verfahrens umfasst der elektro-mechanische Oszillator einen piezo-elektrischen Oszillator, insbesondere einen Quarz-Oszillator bzw. einen Schwingquarz.

Die erfindungsgemäße Vorrichtung zur Unterstützung des Anschwingsvorgangs eines elektro-mechanischen Oszillators bzw. zur Durchführung des erfindungsgemäßen Verfahrens umfasst eine Detektionseinheit zum Detektieren von in dem Ausgangsignal des elektro-mechanischen Oszillators auftretenden Oszillatorschwingungen bzw. von in dem Eigenrauschen des elektro-mechanischen Oszillators vorhandenen Spannungsvariationen, welche beispielsweise durch Rauscheffekte und erste Oszillationen verursacht werden, sowie einen Pulsgenerator zum Erzeugen eines Anregungspulses anhand einer detektierten Oszillatorschwingung, welcher in den elektro-mechanischen Oszillator eingespeist wird. Im Allgemeinen sind die Signallaufzeiten durch die Detektionseinheit und den Pulsgenerator der erfindungsgemäßen Vorrichtung gegenüber der Schwingungsdauer des elektro-mechanischen Oszillators vernachlässigbar, sodass der anhand einer detektierten Oszillatörschwingung erzeugte Anregungspuls auf der Zeitskala der (langsameren) Oszillatorschwingung instantan und somit phasenrichtig in den elektro-mechanischen Oszillator eingespeist wird. Dadurch werden zusätzliche Ladungen in den Quarz getrieben und die Schwingungs-Amplitude des elektro-mechanischen Oszillators wird erhöht.

In einer besonders bevorzugten Ausgestaltung der erfindungsgemäßen Vorrichtung verstärkt die Detektionseinheit die Spannungsvariationen und Oszillatorschwingungen, welche in dem Ausgangssignal des elektro-mechanischen Oszillators auftreten, und generiert daraus ein Taktsignal. Dieses Taktsignal wird dem Pulsgenerator zugeführt. Das Taktsignal repräsentiert daher die in dem Ausgangssignal des elektro-mechanischen Oszillators detektierten Spannungsvariationen und Oszillatorschwingungen und kann somit zum Erzeugen phasenrichtiger Anregungspulse in dem Pulsgenerator herangezogen werden.

In einer besonders bevorzugten Ausgestaltung der erfindungsgemäßen Vorrichtung umfasst die Detektionseinheit eine Inverterkette zum Verstärken von den in dem Ausgangssignal des elektro-mechanischen Oszillators auftretenden Oszillatorschwingungen und zum Erzeugen des Taktsignals. In einer weiteren bevorzugten Ausgestaltung wird zumindest einer der Inverter der Inverterkette, insbesondere jedoch alle Inverter der Inverterkette, am Tripelpunkt betrieben, d.h. der Ausgang des jeweiligen Inverters wird mit seinem Eingang hochohmig rückgekoppelt. Dadurch nehmen im Ruhezustand Eingang und Ausgang des Inverters denselben Spannungswert an, welcher zwischen den beiden logischen Spannungswerten liegt. Der Inverter befindet sich somit in einem Zustand, in dem er die stärkste Verstärkung liefert und auftretende Spannungsvariationen schnell verstärken kann. Durch diesen analogen Betrieb eines Inverters, insbesondere eines CMOS-Inverters, wird ein schneller, einfach aufgebauter Verstärker bereitgestellt.

In einer weiteren bevorzugten Ausgestaltung der erfindungsgemäßen Vorrichtung detektiert bzw. verstärkt der erste Inverter der Inverterkette nur solche Spannungsvariationen bzw. Oszillatorschwingungen des elektro-mechanischen Oszillators, welche einen vorgegebenen Schwellwert übersteigen. Dazu ist der erste Inverter der Inverterkette vorzugsweise als Schmitt-Trigger aufgebaut. Dadurch werden nur solche Spannungsvariationen detektiert bzw. verstärkt, welche beispielsweise mit einer gewissen Sicherheit nicht dem Eigenrauschen des elektro-mechanischen Oszillators zuzurechnen sind.

In einer weiteren bevorzugten Ausgestaltung der erfindungsgemäßen Vorrichtung umfasst der Pulsgenerator einen Univibrator. Der Pulsgenerator nimmt das Taktsignal entgegen, wobei das Taktsignal bevorzugt digital ist. Der Univibrator umfasst zwei Signalpfade, über welche Signale einem logischen Gatter zugeleitet werden. Über den ersten Signalpfad wird das Eingangssignal bzw. das entgegengenommene Taktsignal direkt dem logischen Gatter zugeführt. In dem zweiten Signalpfad, dem Verzögerungspfad, befindet sich eine (ungerade) Anzahl von Invertern, welche eine gewisse Signallaufzeit (Gatterlaufzeit) aufweisen. Das Signal durch den Verzögerungspfad erreicht das logische Gatter somit erst mit einer gewissen Verzögerung, wobei die Signallaufzeit durch die Inverterkette die Pulsdauer des Pulses mitbestimmt, welcher am Ausgang des logischen Gatters abgegeben wird. Je nach Art des logischen Gatters wird beim Auftreten einer ansteigenden oder einer abfallenden Flanke oder bei beiden Flanken des Eingangssignals des Univibrators, d.h. des entgegengenommenen Taktsignals, an dessen Ausgang ein Signalpuls erzeugt. In einer besonders bevorzugten Ausgestaltung befindet sich im Verzögerungspfad des Univibrators ein dem bzw. den Invertern vorgeschaltetes RC-Glied, welches das Umschalten des bzw. der Inverter nach einer Flanke im Taktsignal zusätzlich verzögert und somit die Pulsdauer am Ausgang des logischen Gatters zusätzlich mitbestimmt.

In einer weiteren bevorzugten Ausgestaltung der erfindungsgemäßen Vorrichtung ist der Pulsgenerator zur Entgegennahme eines Freigabesignals ausgelegt und die erfindungsgemäße Vorrichtung umfasst weiterhin eine Einheit zur Erzeugung eines Freigabesignals. Der Pulsgenerator generiert den oder die Anregungspulse in Abhängigkeit des entgegengenommenen Freigabesignals. Das Freigabesignal steuert somit, ob zu einer im Ausgangssignal des elektro-mechanischen Oszillators detektiertenOszillatorschwingung bzw. zu einer in dem Taktsignal auftretenden Flanke ein Anregungspuls generiert und in den elektro-mechanischen Oszillator eingespeist wird oder nicht.

In einer besonders bevorzugten Ausgestaltung ist die Einheit zur Erzeugung des Freigabesignals als Zählwerk ausgelegt, welches die Zeitpunkte bestimmt, zu welchen das Freigabesignal die Generierung des oder der Anregungspulse aus dem Taktsignal durch den Pulsgenerator veranlasst.

In einer besonders bevorzugten Ausgestaltung der erfindungsgemäßen Vorrichtung ist das Zählwerk dazu ausgelegt, das Freigabesignal anhand des von der Detektionseinheit erzeugten Taktsignals zu erzeugen. Beispielsweise wird das Zählwerk mit Hilfe des Taktsignals betrieben.

In einer besonders bevorzugten Ausgestaltung der erfindungsgemäßen Vorrichtung umfasst der elektro-mechanische Oszillator einen piezo-elektrischen Oszillator und ist insbesondere als Quarz-Oszillator bzw. Schwingquarz ausgelegt.

Die erfindungsgemäße Oszillator-Schaltung umfasst eine Oszillatoreinheit mit einem elektro-mechanischen Oszillator sowie eine erfindungsgemäße Vorrichtung zur Unterstützung des Anschwingvorgangs eines elektro-mechanischen Oszillators. Durch das Beifügen der erfindungsgemäßen Vorrichtung zur Unterstützung des Anschwingvorgangs eines elektro-mechanischen Oszillators zu der bekannten Oszillatoreinheit wird gewährleistet, dass ein frequenzstabiles Takt- bzw. Oszillatorsignal bereits nach einer gegenüber dem Stand der Technik deutlich verkürzten Anschwingdauer des elektro-mechanischen Oszillators bereitgestellt wird.

In einer besonders bevorzugten Ausgestaltung ist die Oszillator-Schaltung als Colpitz-Oszillator aufgebaut. Der elektromechanischer Oszillator ist dabei das frequenzbestimmende Glied des Colpitz-Oszillators.

Nachfolgend wird die Erfindung anhand von Zeichnungsfiguren und Datenkurven näher erläutert. Es zeigen:
- Fig. 1: den gemessenen Anschwingvorgang eines elektromechanischen Oszillators gemäß dem Stand der Technik;
- Fig. 2: ein Ausführungsbeispiel der erfindungsgemäßen Vorrichtung;
- Fig. 3: eine Simulation des Anschwingverhaltens bei Anwendung des erfindungsgemäßen Verfahrens; und
- Fig. 4: einen Vergleich des aus der Anwendung des erfindungsgemäßen Verfahrens resultierenden Anschwingverhaltens mit dem bekannten Anschwingverhalten.

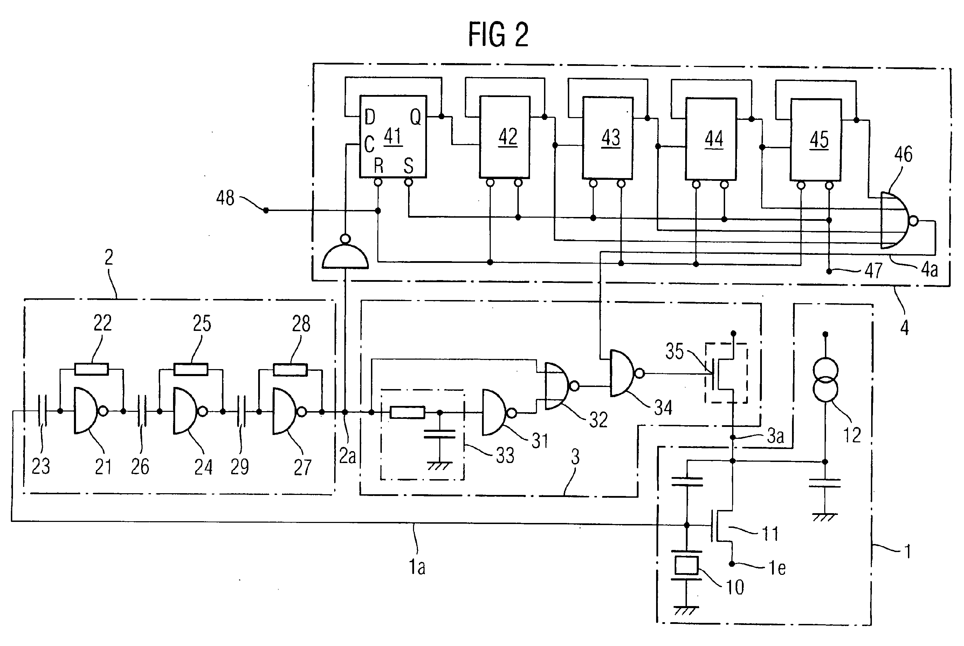

In Fig. 2 ist das Schaltbild eines Ausführungsbeispiels der erfindungsgemäßen Oszillator-Schaltung dargestellt. Die Oszillator-Schaltung umfasst eine Oszillatoreinheit 1 mit einem Quarz-Oszillator bzw. Schwingquarz 10. Eine gesteuerte Stromquelle 12 versorgt einen Schalttransistor 11, dessen Gate durch den Schwingquarz 10 gesteuert wird. Die gesteuerte Stromquelle 12 kann beispielsweise derart gesteuert werden, dass sie während des Anschwingvorgangs eine höhere Spannung abgibt, um den Anschwingvorgang zu beschleunigen. Am Anschluss 1e des Schalttransistors wird ein frequnzstabilisiertes Taktsignal abgegeben. Das Ausgangssignal des Schwingquarzes 10 wird über die Zuleitung 1a (XTAL) einer Detektionseinheit 2 zugeführt. Ein Pulsgenerator 3 speist phasenrichtige Anregungspulse 3b über die Zuleitung 3a (LOAD PIN) in die Oszillatoreinheit 1 ein.

Unmittelbar nach dem Einschalten der Versorgungsspannung der Oszillatoreinheit 1 ist der Schwingquarz 10 noch nicht eingeschwungen und das Ausgangssignal des Schwingquarzes 10 (auf der Zuleitung la) enthält im Wesentlichen das Eigenrauschen des Schwingquarzes 10 sowie Rauscheffekte und erste unregelmäßige Oszillationen, welche in der Detektionseinheit 2 detektiert und in ein digitales Taktsignal abgebildet werden.

Im vorliegenden Ausführungsbeispiel enthält die Detektionseinheit 2 dazu eine Inverterkette aus drei Invertern 21, 24, 27, welche durch Koppel-Kondensatoren 23, 26, 29 gleichstrommäßig voneinander und von der Oszillatoreinheit 1 getrennt sind. Die Inverter 21, 24, 27 werden am sogenannten Tripelpunkt betrieben, d.h. der Ausgang der Inverter 21, 24, 27 wird über Widerstände 22, 25, 28 hochohmig mit dem jeweiligen Eingang rückgekoppelt. Anstelle der Widerstände 22, 25, 28 können auch jeweils hochohmige Transistoren verwendet werden. Die hochohmige Rückkopplung 22, 25, 28 der einzelnen Inverter 21, 24, 27 wird derart dimensioniert, dass im Ruhezustand die Spannung am Ein- und Ausgang eines Inverters 21, 24, 27 identisch ist. Der Widerstandswert liegt typischerweise bei 200 kΩ. Die Spannung am Ein- und Ausgang liegt dabei in der Mitte zwischen den beiden logischen Spannungswerten, d.h. liegen die beiden logischen Spannungswerte beispielsweise bei 0 und 2,5 V, so stellt sich durch die hochohmige Rückkopplung der Inverter 21, 24, 27 an deren Ein- und Ausgängen eine Spannung von 1,25 V ein. Die Inverter 21, 24, 27 arbeiten dadurch als schnelle Verstärker. Falls am Eingang des ersten Inverters 21 Spannungsschwankungen infolge von Rauscheffekten oder ersten Oszillationen des Schwingquarzes 10 auftreten, so werden diese verstärkt und an den nächsten Inverter 24 weitergereicht. Sofern am Eingang eines Inverters 21, 24, 27 Spannungsvariationen von beispielsweise 10 mV auftreten, so werden diese typischerweise auf ca. 100 mV verstärkt. Die Verstärkung ist durch die logischen Spannungswerte begrenzt, welche typischerweise zugleich die Versorgungsspannung der Inverter 21, 24, 27 sowie Masse darstellt. Die Detektionseinheit 2 gibt daher ein digitales Taktsignal 2a ab, welches anhand des analogen Ausgangssignals des Schwingquarzes 10 erzeugt wird.

Vorzugsweise ist der erste Inverter 21 als Schmitt-Trigger aufgebaut, welcher Spannungs-Oszillationen am Eingang erst ab einem einstellbaren Schwellwert verstärkt und vorzugsweise eine Hysterese in seinem Verstärkungsverhalten aufweist.

Die Detektionseinheit 2 detektiert somit in dem Ausgangssignal des Schwingquarzes 10 auftretende Rauscheffekte und Oszillatorschwingungen 1b und formt daraus ein digitales Taktsignal 2a, welches am Ausgang der Detektionseinheit 2 ausgegeben wird.

Das digitale Taktsignal 2a wird an ein Zählwerk 4 und den Pulsgenerator 3 weitergereicht.

Der Pulsgenerator 3 enthält einen Univibrator 31, 32, welcher einen Inverter (Flankenerkenner) 31 und eine Differenzierschaltung 32, mit deren Hilfe aus dem digitalen Taktsignal 2a kurze Pulse 3b erzeugt werden, umfasst. Liegt am Eingang des Pulsgenerators 3 eine logische 1 an, so liegt am Ausgang des Inverters 31 eine logische 0 an. An den Eingängen des NOR-Gatters 32 liegt somit eine logische 0 und eine logische 1 an, sodass das NOR-Gatter 32 eine logische 0 ausgibt. Wechselt das digitale Taktsignal 2a auf den logischen Wert 0, so liegt (auf Grund der Gatterlaufzeit in dem Inverter 31) am Ausgang des Inverters 31 zunächst weiterhin eine logische 0 an. An beiden Eingängen des NOR-Gatters 32 liegt somit eine logische 0 an und das NOR-Gatter 32 gibt eine logische 1 aus. Nach der Gatter-Laufzeit des Inverters 31 wechselt dessen Ausgang auf logisch 1 und der Ausgang des NOR-Gatters 32 wechselt wieder auf den logischen Wert 0. Das NOR-Gatter 32 gibt somit kurze Pulse ab, deren Dauer von der Signallaufzeit in dem Verzögerungspfad abhängen. Zusätzlich ist dem Inverter 31 ein RC-Glied 33 vorgeschaltet, welches das Umschalten des Inverters 31 verzögert und die Pulsdauer am Ausgang des NOR-Gatters 32 weiter verlängert.

Der Ausgang der NOR-Gatters 32 ist mit einem Eingang eines NAND-Gatters 34 verbunden. Der zweite Eingang des NAND-Gatters 34 ist an eine Zuleitung 4a gekoppelt. Sofern auf der Zuleitung 4a das Freigabesignal (logisch 1) anliegt, werden die am Ausgang des NOR-Gatters 32 bereitgestellten Pulse durch das NAND-Gatter 34 geleitet. Der Ausgang des NAND-Gatters 34 wechselt während der Pulsdauer auf den logischen Wert 0 und öffnet somit das Gate eines PMOS-Transistors 35. Dadurch werden Anregungspulse 3b generiert und über die Zuleitung 3a an die Oszillatoreinheit 1 bzw. an den Schwingquarz 10 abgegeben. Die Signallaufzeit durch die Detektionseinheit 2 und den Pulsgenerator 3 ist nur durch die Gatterlaufzeiten bestimmt und daher gegenüber der Schwingungsdauer des Schwingquarzes 10 vernachlässigbar, sodass die an den Schwingquarz abgegebenen Anregungspulse 3b phasensynchron zu der detektierten Oszillation 1c des Schwingquarzes 10 abgegeben werden und somit zusätzliche Ladungen in den Quarz-Oszillator 10 getrieben werden. Rauscheffekte und erste Oszillationen des Schwingquarzes 10 werden instantan und somit phasenrichtig verstärkt.

Das Zählwerk 4 weist im vorliegenden Ausführungsbeispiel fünf hintereinander geschaltete Toggle-Flipflops 41, 42, 43, 44, 45 auf, welche so beschaltet sind, dass sie das jeweils anliegende Taktsignal (Eingang C) durch den Faktor 2 teilen. Das Zählwerk 4 kann somit 2⁵ = 32 verschiedene Zustände annehmen. Jedes Flipflop 41, 42, 43, 44, 45 weist einen Set- S und einen Reset- R -Eingang auf und der Ausgang Q ist mit dem jeweiligen Dateneingang D rückgekoppelt. Das digitale Taktsignal 2a liegt an dem Takteingang C des ersten Flipflops 41 an. Der Ausgang der Flipflops 41, 42, 43, 44 liegt an dem Takteingang C des jeweils nachfolgenden Flipflops 42, 43, 44, 45 an. Zudem wird das Ausgangssignal Q der vier "höherwertigen" Flipflops 42, 43, 44, 45 einem NOR-Gatter 46 zugeführt. Liegt an allen vier Eingängen des NOR-Gatters 46 eine logische 0 an, so wird das Freigabesignal in Form einer logischen 1 über die Zuleitung 4a dem Pulsgenerator 3 zugeführt. Das Freigabesignal wird somit nur bei den Zählerständen 30 und 31 des Zählwerks 4 an den Pulsgenerator 3 abgegeben. Liegt das Freigabesignal nicht an der Zuleitung 4a an bzw. liegt dort eine logische 0 an, so blockiert das NAND-Gatter 34 die von dem NOR-Gatter 32 abgegebenen Pulse und es werden keine Anregungspulse generiert und in den Schwingquarz 10 eingespeist. Der vorliegende Aufbau des Zählwerks 4 erzeugt drei Anregungspulse (beim Wechsel auf die Zählerstände 30, 31 und 0) pro 32 detektierten Oszillatorschwingungen 1b in dem Ausgangssignal des Schwingquarzes 10. Der Aufbau des Zählwerkes 4 kann jedoch beliebig verändert werden, sodass unterschiedliche Anregungspulssequenzen an den Schwingquarz 10 abgegeben werden. Beispielsweise können die Ausgänge der Flipflops 41, 42, 43, 44, 45 am Eingang des NOR-Gatters 46 beliebig kombiniert werden, um die gewünschte Anzahl und Abfolge von Pulssequenzen pro Zählerdurchlauf an den Schwingquarz 10 abzugeben. Es ist auch denkbar, die Anzahl der Flipflops 41, 42, 43, 44, 45 zu verändern, um die Anzahl der Zustände des Zählwerkes 4 zu erhöhen oder zu erniedrigen. Zudem können auch komplexer aufgebaute Zählwerke verwendet werden.

Die Set- S und Reset- R -Eingänge der Flipflops 41, 42, 43, 44, 45 werden über externe Zuleitungen 47, 48 gesteuert. Das Zählwerk 4 und die Einspeisung der Anregungspulse kann somit extern an- und abgeschaltet werden.

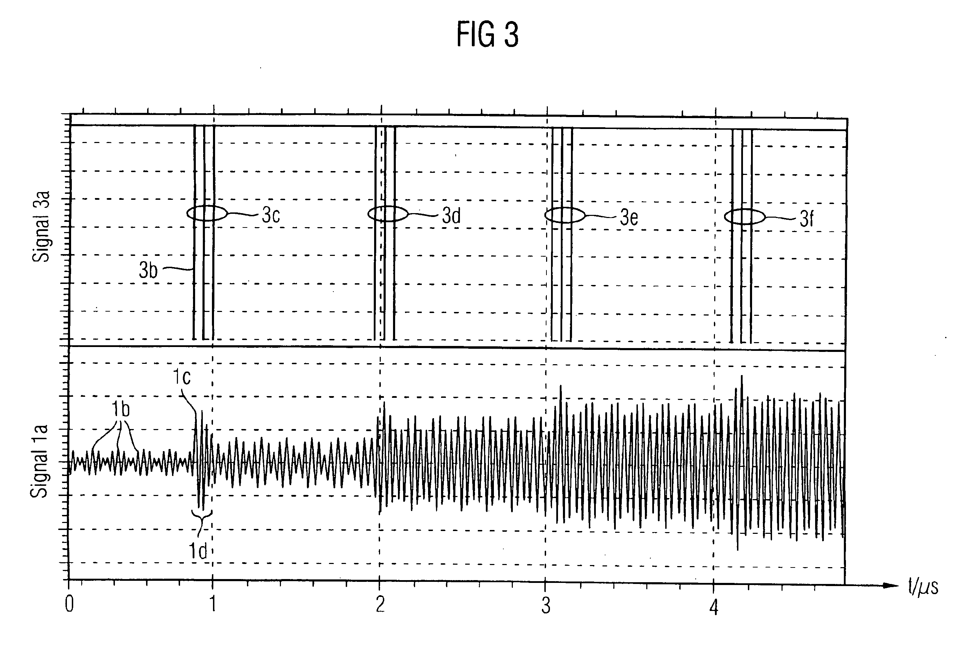

Im unteren Teil von Fig. 3 ist eine Simulation des Ausgangssignals 1a (XTAL) des Schwingquarzes 10 bei Anwendung des erfindungsgemäßen Verfahrens dargestellt. Im oberen Teil von Fig. 3 sind die durch den Pulsgenerator 3 auf der Zuleitung 3a (LOAD PIN) abgegebenen Pulse dargestellt. Pro Durchlauf des Zählwerks 4, d.h. im vorliegenden Fall bei fünf Flipflops 41, 42, 43, 44, 45 pro 2⁵ = 32 im Ausgangssignal 1a des Schwingquarzes 10 detektierten Oszillatorschwingungen 1b, werden drei Anregungspulse 3c abgegeben. Diese Anregungspulssequenz 3c wiederholt sich mit jedem Durchlauf des Zählwerks 4 und ist in Fig. 3 durch die Bezugszeichen 3d, 3e, 3f gekennzeichnet. Die einzelnen Anregungspulse 3b einer Pulssequenz 3c entsprechen drei aufeinander folgenden detektierten Oszillatorschwingungen 1d des Schwingquarzes 10. Im vorliegenden Ausführungsbeispiel beträgt die Schwingungsfrequenz des Schwingquarzes 10 ca. 26 MHz, d.h. ein Zählerdurchlauf, welcher 32 Oszillatorschwingungen 1b entspricht, dauert etwas über 1 µs. Dem unteren Tei von Fig. 3 ist zu entnehmen, dass die Oszillations-Amplitude des Schwingquarzes 10 pro Zählerdurchlauf, d.h. pro abgegebener Pulssequenz 3c, 3d, 3e, 3f, signifikant zunimmt, sodass bereits nach wenigen Mikrosekunden bzw. nach der Einspeisung weniger Anregungspulse 3b in den Quarz-Oszillator 10 die Schwingungs-Amplitude des Schwingquarzes 10 beträchtlich zugenommen hat.

Eine Schwingungsfrequenz von ca. 26 MHz entspricht einer Schwingungsdauer von ca. 38 ns, während die Signallaufzeit durch die Detektionseinheit 2 und den Pulsgenerator 3 im Bereich von 1 ns liegt. Die Anregungspulse werden daher mit einer gegenüber der Schwingungsdauer vernachlässigbaren Verzögerung und somit ausreichend phasenrichtig in den Quarz-Oszillator 10 eingespeist.

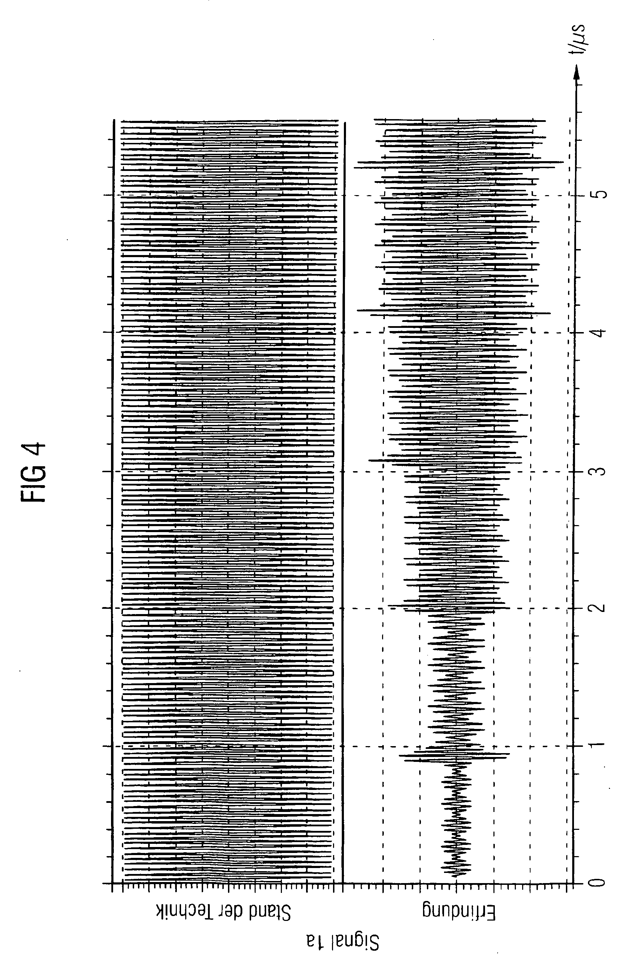

In Fig. 4 ist das Anschwingen eines Schwingquarzes 10 gemäß dem Stand der Technik (oberer Teil) dem Anschwingen eines Schwingquarzes 10 bei Anwendung des erfindungsgemäßen Verfahrens (unterer Teil) gegenübergestellt. Wie bereits oben erwähnt, steigt die Oszillator-Amplitude des Schwingquarzes 10 bei Anwendung des erfindungsgemäßen Verfahrens innerhalb weniger Mikrosekunden beträchtlich an. Demgegenüber nimmt die Oszillator-Amplitude des Schwingquarzes 10 in dem gleichen Zeitraum beim Anschwingen gemäß dem Stand der Technik nur geringfügig zu (die Skalierung des Graphen im oberen Teil von Fig. 4 ist hier unerheblich).

Nach Beendigung des Anschwingvorgangs, d.h. sobald die Oszillation des Schwingquarzes 10 eine gewisse Amplitude überschritten hat, können die Detektionseinheit 2, der Pulsgenerator 3 und das Zählwerk 4 abgeschaltet werden.

## Patentansprüche

1. Verfahren zur Unterstützung des Anschwingvorgangs eines elektro-mechanischen Oszillators (10), umfassend ein Rückkoppel-Verfahren mit den Schritten:
a) Detektieren von in dem Ausgangssignal (1a) des elektro-mechanischen Oszillators (10) auftretenden Oszillatorschwingungen (1b, 1c);
b) Generieren eines Anregungspulses (3b) anhand einer detektierten Oszillatorschwingung (1c); und
c) Einspeisen (3a) des Anregungspulses (3b) in den elektro-mechanischen Oszillator (10),
**dadurch gekennzeichnet,**
**dass** der Anregungspuls (3b) phasensynchron zu der detektierten Oszillatorschwingung (1c) in den elektro-mechanischen Oszillator (10) eingespeist wird.

2. Verfahren nach Anspruch 1,
**dadurch gekennzeichnet,**
**dass** das Detektieren der Oszillatorschwingungen (1b, 1c) die Schritte umfasst:
- Verstärken von in dem Ausgangssignal (1a) des elektro-mechanischen Oszillators (10) auftretenden Oszillatorschwingungen (1b, 1c); und
- Generieren eines Taktsignals (2a) anhand der verstärkten Oszillatorschwingungen (1b, 1c).

3. Verfahren nach Anspruch 1 oder 2,
**dadurch gekennzeichnet,**
**dass** das Generieren (3a) des Anregungspulses (3b) in Abhängigkeit eines Freigabesignals (4a) erfolgt, wobei der Zeitpunkt, zu dem das Freigabesignal (4a) die Generierung des Anregungspulses (3b) veranlasst, insbesondere vorgegeben ist.

4. Verfahren nach Ansprüchen 2 und 3,
**dadurch gekennzeichnet,**
**dass** das Freigabesignal (4a) mit Hilfe des Taktsignals (2a) erzeugt wird.

5. Verfahren nach einem der vorhergehenden Ansprüche,
**dadurch gekennzeichnet,**
**dass** eine Mehrzahl von Anregungspulsen (3c) in den elektro-mechanischen Oszillator (10) eingespeist wird, indem das Rückkoppel-Verfahren mehrfach ausgeführt wird.

6. Verfahren nach Anspruch 5,
**dadurch gekennzeichnet,**
**dass** periodisch Gruppen von Anregungspulsen (3c, 3d, 3e, 3f) in den elektro-mechanischen Oszillator (10) eingespeist werden, wobei jede Gruppe (3c, 3d, 3e, 3f) mindestens einen Anregungspuls (3b) umfasst.

7. Verfahren nach Anspruch 6,
**dadurch gekennzeichnet,**
**dass** innerhalb einer Gruppe von Anregungspulsen (3c, 3d, 3e, 3f) eine vorgegebene Anzahl von Anregungspulsen in den elektro-mechanischen Oszillator (10) eingespeist wird, wobei die Anregungspulse der Gruppen (3c, 3d, 3e, 3f) anhand von aufeinander folgenden, detektierten Oszillatorschwingungen (1b) generiert werden.

8. Verfahren nach Anspruch 6 oder 7,
**dadurch gekennzeichnet,**
**dass** während der Zeitabschnitte zwischen dem Einspeisen der Gruppen von Anregungspulsen (3c, 3d, 3e, 3f) keine Anregungspulse in den elektro-mechanischen Oszillator (10) eingespeist werden.

9. Verfahren nach einem der vorhergehenden Ansprüche,
**dadurch gekennzeichnet,**
**dass** die Oszillatorschwingungen (1b) des elektro-mechanischen Oszillators (10) detektiert werden, die einen Schwellwert übersteigen.

10. Verfahren nach einem der vorhergehenden Ansprüche,
**dadurch gekennzeichnet,**
**dass** der elektro-mechanische Oszillator (10) einen piezoelektrischen Oszillator, insbesondere einen Quarz-Oszillator, umfasst.

11. Vorrichtung zur Unterstützung des Anschwingvorgangs eines elektro-mechanischen Oszillators (10), umfassend:
- eine Detektionseinheit (2) zum Detektieren von in dem Ausgangssignal (1a) des elektro-mechanischen Oszillators (10) auftretenden Oszillatorschwingungen (1b, 1c), und
- einen Pulsgenerator (3) zum Generieren eines Anregungspulses (3b) anhand einer detektierten Oszillatorschwingung (1c), welcher in den elektro-mechanischen Oszillator (10) eingespeist (3a) wird,
**dadurch gekennzeichnet,**
**dass** der Pulsgenerator (3) dazu ausgelegt ist, den Anregungspuls (3b) phasensynchron zu der detektierten Oszillatorschwingung (1c) in den elektro-mechanischen Oszillator (10) einzuspeisen.

12. Vorrichtung nach Anspruch 11,
**dadurch gekennzeichnet,**
**dass** die Detektionseinheit (2) zum Verstärken von in dem Ausgangssignal (1a) des elektro-mechanischen Oszillators (10) auftretenden Oszillatorschwingungen (1b, 1c) und zum Generieren eines Taktsignals (2a) anhand der verstärkten Oszillatorschwingungen (1b, 1c) ausgelegt ist.

13. Vorrichtung nach Anspruch 12,
**dadurch gekennzeichnet,**
**dass** die Detektionseinheit (2) eine Inverterkette (21, 24, 27) umfasst und insbesondere zumindest einer der Inverter der Inverterkette (21, 24, 27) am Tripelpunkt betrieben wird.

14. Vorrichtung nach Anspruch 13,
**dadurch gekennzeichnet,**
**dass** der erste Inverter (21) der Inverterkette (21, 24, 27) die Oszillatorschwingungen (1b, 1c) des elektro-mechanischen Oszillators (10) detektiert, die einen Schwellwert übersteigen, und dieser insbesondere als Schmitt-Trigger aufgebaut ist.

15. Vorrichtung nach einem der Ansprüche 11 bis 14,
**dadurch gekennzeichnet,**
**dass** der Pulsgenerator (3) einen Univibrator (31, 32) umfasst und dass in dem Verzögerungspfad (31) des Univibrators (31, 32) insbesondere ein RC-Glied (33) angeordnet ist.

16. Vorrichtung nach einem der Ansprüche 11 bis 15,
**gekennzeichnet durch,**
- eine Einheit (4) zur Erzeugung eines Freigabesignals (4a), wobei der Pulsgenerator (3) zur Entgegennahme des Freigabesignals (4a) ausgelegt ist und den oder die Anregungspulse (3b) in Abhängigkeit des Freigabesignals (4a) in den elektro-mechanischen Oszillator (10) einspeist (3a), und
- insbesondere ein Zählwerk (4), das in Abhängigkeit von dem Taktsignal (2a) den oder die Zeitpunkte, zu welchen das Freigabesignal (4a) die Einspeisung des oder der Anregungspulse (3b) in den elektro-mechanischen Oszillator (10) veranlasst, bestimmt.

17. Vorrichtung nach Anspruch 16,
**dadurch gekennzeichnet,**
**dass** das Zählwerk (4) dazu ausgelegt ist, das Freigabesignal (4a) mit Hilfe des Taktsignals (2a) zu erzeugen.

18. Vorrichtung nach Anspruch 16 oder 17,
**dadurch gekennzeichnet,**
**dass** die Einheit (4) zur Erzeugung des Freigabesignals (4a) dazu ausgelegt ist, die Einspeisung einer Mehrzahl von Anregungspulsen (3c, 3d, 3e, 3f) in den elektro-mechanischen Oszillator (10) zu veranlassen.

19. Vorrichtung nach Anspruch 18,
**dadurch gekennzeichnet,**
**dass** die Einheit (4) zur Erzeugung des Freigabesignals (4a) dazu ausgelegt ist, die periodische Einspeisung von Gruppen von Anregungspulsen (3c, 3d, 3e, 3f) in den elektro-mechanischen Oszillator (10) zu veranlassen, wobei jede Gruppe (3c, 3d, 3e, 3f) mindestens einen Anregungspuls (3b) umfasst.

20. Vorrichtung nach Anspruch 19,
**dadurch gekennzeichnet,**
**dass** die Einheit (4) zur Erzeugung des Freigabesignals (4a) dazu ausgelegt ist, innerhalb einer Gruppe von Anregungspulsen (3c, 3d, 3e, 3f) die Einspeisung einer vorgegebenen Anzahl von Anregungspulsen (3b) in den elektro-mechanischen Oszillator (10) zu veranlassen, wobei die Anregungspulse (3b) der Gruppen (3c, 3d, 3e, 3f) anhand von aufeinander folgenden, detektierten Oszillatorschwingungen (1b, 1c) generiert werden.

21. Vorrichtung nach Anspruch 19 oder 20,
**dadurch gekennzeichnet,**
**dass** die Einheit (4) zur Erzeugung des Freigabesignals (4a) dazu ausgelegt ist zu veranlassen, dass während der Zeitabschnitte zwischen dem Generieren der Gruppen von Anregungspulsen (3c, 3d, 3e, 3f) keine Anregungspulse in den elektro-mechanischen Oszillator (10) eingespeist werden.

22. Vorrichtung nach einem der Ansprüche 11 bis 21,
**dadurch gekennzeichnet,**
**dass** der elektro-mechanische Oszillator (10) einen piezoelektrischen Oszillator, insbesondere einen Quarz-Oszillator, umfasst.

23. Oszillator-Schaltung umfassend
- eine Oszillator-Einheit (1) mit einem elektro-mechanischen Oszillator (10), und
- eine Vorrichtung nach einem der Ansprüche 11 bis 22.

24. Oszillator-Schaltung nach Anspruch 23,
**dadurch gekennzeichnet,**
**dass** die Oszillator-Einheit (1) als Colpitz-Oszillator aufgebaut ist.

## Claims

1. Method for assisting the oscillation starting process of an electromechanical oscillator (10), comprising a feedback method with the following steps:
a) detection of oscillator oscillations (1b, 1c) which occur in the output signal (1a) from the electromechanical oscillator (10);
b) generation of an excitation pulse (3b) on the basis of a detected oscillator oscillation (1c); and
c) feeding (3a) of the excitation pulse (3b) to the electromechanical oscillator (10),
**characterized**
**in that** the excitation pulse (3b) is fed into the electromechanical oscillator (10) with its phase synchronized to that of the detected oscillator oscillation (1c).

2. Method according to Claim 1,
**characterized**
**in that** the detection of the oscillator oscillations (1b, 1c) comprises the following steps:
- amplification of oscillator oscillations (1b, 1c) which occur in the output signal (1a) from the electromechanical oscillator (10); and
- generation of a clock signal (2a) on the basis of the amplified oscillator oscillations (1b, 1c).

3. Method according to Claim 1 or 2,
**characterized**
**in that** the excitation pulse (3b) is generated (3a) as a function of an enable signal (4a), with the time at which the enable signal (4a) causes the generation of the excitation pulse (3b) being, in particular, predetermined.

4. Method according to Claims 2 and 3,
**characterized**
**in that** the enable signal (4a) is produced with the aid of the clock signal (2a).

5. Method according to one of the preceding claims,
**characterized**
**in that** a plurality of excitation pulses (3c) are fed to the electromechanical oscillator (10), by carrying out the feedback method repeatedly.

6. Method according to Claim 5,
**characterized**
**in that** groups of excitation pulses (3c, 3d, 3e, 3f) are fed to the electromechanical oscillator (10) periodically, with each group (3c, 3d, 3e, 3f) comprising at least one excitation pulse (3b).

7. Method according to Claim 6,
**characterized**
**in that** a predetermined number of excitation pulses are fed to the electromechanical oscillator (10) within one group of excitation pulses (3c, 3d, 3e, 3f), with the excitation pulses in the groups (3c, 3d, 3e, 3f) being generated on the basis of successive, detected oscillator oscillations (1b).

8. Method according to Claim 6 or 7,
**characterized**
**in that** no excitation pulses are fed to the electromechanical oscillator (10) during the time period between the feeding of the groups of excitation pulses (3c, 3d, 3e, 3f).

9. Method according to one of the preceding claims,
**characterized**
**in that** the oscillator oscillations (1b) of the electromechanical oscillator (10) which exceed a threshold value are detected.

10. Method according to one of the preceding claims,
**characterized**
**in that** the electromechanical oscillator (10) comprises a piezoelectric oscillator, in particular a crystal oscillator.

11. Apparatus for assisting the oscillation starting process of an electromechanical oscillator (10), comprising:
- a detection unit (2) for detection of oscillator oscillations (1b, 1c) which occur in the output signal (1a) from the electromechanical oscillator (10), and
- a pulse generator (3) for generation of an excitation pulse (3b) on the basis of a detected oscillator oscillation (1c) which is fed (3a) to the electromechanical oscillator (10),
**characterized**
**in that** the pulse generator (3) is designed to feed the excitation pulse (3b) into the electromechanical oscillator (10) with its phase synchronized to that of the detected oscillator oscillation (1c).

12. Apparatus according to Claim 11,
**characterized**
**in that** the detection unit (2) is designed to amplify oscillator oscillations (1b, 1c) which occur in the output signal (1a) from the electromechanical oscillator (10), and for generation of a clock signal (2a) on the basis of the amplified oscillator oscillations (1b, 1c).

13. Apparatus according to Claim 12,
**characterized**
**in that** the detection unit (2) comprises an inverter chain (21, 24, 27) and, in particular, at least one of the inverters in the inverter chain (21, 24, 27) is operated at the triple point.

14. Apparatus according to Claim 13,
**characterized**
**in that** the first inverter (21) in the inverter chain (21, 24, 27) detects those oscillator oscillations (1b, 1c) in the electromechanical oscillator (10) which exceed a threshold value, and this first inverter (21) is, in particular, in the form of a Schmitt trigger.

15. Apparatus according to one of Claims 11 to 14,
**characterized**
**in that** the pulse generator (3) comprises a univibrator (31, 32), and in that, in particular, an RC element (33) is arranged in the delay path (31) of the univibrator (31, 32).

16. Apparatus according to one of Claims 11 to 15,
**characterized by**
- a unit (4) for production of an enable signal (4a), with the pulse generator (3) being designed to receive the enable signal (4a) and feeding (3a) the excitation pulse or pulses (3b) to the electromechanical oscillator (10) as a function of the enable signal (4a), and
- in particular, a counter (4) which uses the clock signal (2a) to determine the time or times at which the enable signal (4a) causes the excitation pulse or pulses (3b) to be fed to the electromechanical oscillator (10).

17. Apparatus according to Claim 16,
**characterized**
**in that** the counter (4) is designed to produce the enable signal (4a) with the aid of the clock signal (2a).

18. Apparatus according to Claim 16 or 17,
**characterized**
**in that** the unit (4) for production of the enable signal (4a) is designed to cause a plurality of excitation pulses (3c, 3d, 3e, 3f) to be fed to the electromechanical oscillator (10).

19. Apparatus according to Claim 18,
**characterized**
**in that** the unit (4) for production of the enable signal (4a) is designed to cause groups of excitation pulses (3c, 3d, 3e, 3f) to be fed to the electromechanical oscillator (10) periodically, with each group (3c, 3d, 3e, 3f) comprising at least one excitation pulse (3b).

20. Apparatus according to Claim 19,
**characterized**
**in that** the unit (4) for production of the enable signal (4a) is designed to cause a predetermined number of excitation pulses (3b) to be fed to the electromechanical oscillator (10) within one group of excitation pulses (3c, 3d, 3e, 3f), with the excitation pulses (3b) in the groups (3c, 3d, 3e, 3f) being generated on the basis of successive detected oscillator oscillations (1b, 1c).

21. Apparatus according to Claim 19 or 20,
**characterized**
**in that** the unit (4) for production of the enable signal (4a) is designed to ensure that no excitation pulses are fed to the electromechanical oscillator (10) during the time periods between the generation of the groups of excitation pulses (3c, 3d, 3e, 3f).

22. Apparatus according to one of Claims 11 to 21,
**characterized**
**in that** the electromechanical oscillator (10) comprises a piezoelectric oscillator, in particular a crystal oscillator.

23. Oscillator circuit comprising
- an oscillator unit (1) with an electromechanical oscillator (10), and
- an apparatus according to one of Claims 11 to 22.

24. Oscillator circuit according to Claim 23,
**characterized**
**in that** the oscillator unit (1) is in the form of a Colpitz oscillator.

## Revendications

1. Procédé de soutien de l'opération de démarrage d'un oscillateur électromécanique (10), comprenant un procédé de rétroaction avec les étapes de :
a) détection d'oscillations d'oscillateur (1b, 1c) apparaissant dans le signal de sortie (1a) de l'oscillateur électromécanique (10) ;
b) génération d'une impulsion d'excitation (3b) à l'aide d'une oscillation d'oscillateur (1c) détectée ; et
c) introduction (3a) de l'impulsion d'excitation (3b) dans l'oscillateur électromécanique (10),
**caractérisé par le fait que**
l'on introduit l'impulsion d'excitation (3b) dans l'oscillateur électromécanique (10) avec une phase synchrone par rapport à l'oscillation d'oscillateur (1c) détectée.

2. Procédé selon la revendication 1,
**caractérisé par le fait que**
la détection des oscillations d'oscillateur (1b, 1c) comprend les étapes de :
- amplification d'oscillations d'oscillateur (1b, 1c) apparaissant dans le signal de sortie (1a) de l'oscillateur électromécanique (10) ; et
- génération d'un signal d'horloge (2a) à l'aide des oscillations d'oscillateur (1b, 1c) amplifiées.

3. Procédé selon la revendication 1 ou 2,
**caractérisé par le fait que**
la génération (3a) de l'impulsion d'excitation (3b) s'effectue en fonction d'un signal d'activation (4a), l'instant auquel le signal d'activation (4a) provoque la génération de l'impulsion d'excitation (3b) étant notamment prédéterminé.

4. Procédé selon les revendications 2 et 3,
**caractérisé par le fait que**
l'on produit le signal d'activation (4a) à l'aide du signal d'horloge (2a).

5. Procédé selon l'une des revendications précédentes,
**caractérisé par le fait que**
l'on introduit plusieurs impulsions d'excitation (3c) dans l'oscillateur électromécanique (10) en exécutant plusieurs fois le procédé de rétroaction.

6. Procédé selon la revendication 5,
**caractérisé par le fait que**
l'on introduit périodiquement des groupes d'impulsions d'excitation (3c, 3d, 3e, 3f) dans l'oscillateur électromécanique (10), chaque groupe (3c, 3d, 3e, 3f) comprenant au moins une impulsion d'excitation (3b).

7. Procédé selon la revendication 6,
**caractérisé par le fait que**,
à l'intérieur d'un groupe d'impulsions d'excitation (3c, 3d, 3e, 3f), on introduit un nombre prédéterminé d'impulsions d'excitation dans l'oscillateur électromécanique (10), les impulsions d'excitation des groupes (3c, 3d, 3e, 3f) étant générées à l'aide d'oscillations d'oscillateur (1b) détectées successives.

8. Procédé selon la revendication 6 ou 7,
**caractérisé par le fait que**,
pendant les intervalles de temps entre l'introduction des groupes d'impulsions d'excitation (3c, 3d, 3e, 3f), on n'introduit pas d'impulsion d'excitation dans l'oscillateur électromécanique (10).

9. Procédé selon l'une des revendications précédentes,
**caractérisé par le fait que**
l'on détecte les oscillations d'oscillateur (1b) de l'oscillateur électromécanique (10) qui dépassent un seuil.

10. Procédé selon l'une des revendications précédentes,
**caractérisé par le fait que**
l'oscillateur électromécanique (10) comprend un oscillateur piézoélectrique, notamment un oscillateur à quartz.

11. Dispositif de soutien de l'opération de démarrage d'un oscillateur électromécanique (10), comprenant :
- une unité de détection (2) pour détecter des oscillations d'oscillateur (1b, 1c) apparaissant dans le signal de sortie (1a) de l'oscillateur électromécanique (10), et
- un générateur d'impulsions (3) pour générer une impulsion d'excitation (3b) à l'aide d'une oscillation d'oscillateur (1c) détectée, laquelle impulsion d'excitation est introduite (3a) dans l'oscillateur électromécanique (10),
**caractérisé par le fait que**
le générateur d'impulsions (3) est conçu pour introduire l'impulsion d'excitation (3b) dans l'oscillateur électromécanique (10) avec une phase synchrone par rapport à l'oscillation d'oscillateur (1c) détectée.

12. Dispositif selon la revendication 11,
**caractérisé par le fait que**
l'unité de détection (2) est conçue pour amplifier des oscillations d'oscillateur (1b, 1c) apparaissant dans le signal de sortie (1a) de l'oscillateur électromécanique (10) et pour générer un signal d'horloge (2a) à l'aide des oscillations d'oscillateur (1b, 1c) amplifiées.

13. Dispositif selon la revendication 12,
**caractérisé par le fait que**
l'unité de détection (2) comprend une chaîne d'inverseurs (21, 24, 27) et que notamment au moins l'un des inverseurs de la chaîne d'inverseurs (21, 24, 27) fonctionne au point triple.

14. Dispositif selon la revendication 13,
**caractérisé par le fait que**
le premier inverseur (21) de la chaîne d'inverseurs (21, 24, 27) détecte les oscillations d'oscillateur (1b, 1c) de l'oscillateur électromécanique (10) qui dépassent une valeur de seuil et que celui-ci est conçu notamment comme un trigger de Schmitt.

15. Dispositif selon l'une des revendications 11 à 14,
**caractérisé par le fait que**
le générateur d'impulsions (3) comprend un univibrateur (31, 32) et que notamment un circuit RC (33) est monté dans la voie de retardement (31) de l'univibrateur (31, 32).

16. Dispositif selon l'une des revendications 11 à 15,
**caractérisé par**:
- une unité (4) pour la production d'un signal d'activation (4a), le générateur d'impulsions (3) étant conçu pour la réception du signal d'activation (4a) et introduisant (3a) le ou les impulsions d'excitation (3b) dans l'oscillateur électromécanique (10) en fonction du signal d'activation (4a), et
- notamment un mécanisme de comptage (4) qui détermine en fonction du signal d'horloge (2a) le ou les instants auxquels le signal d'activation (4a) provoque l'introduction de l'impulsion ou des impulsions d'excitation (3b) dans l'oscillateur électromécanique (10).

17. Dispositif selon la revendication 16,
**caractérisé par le fait que**
le mécanisme de comptage (4) est conçu pour produire le signal d'activation (4a) à l'aide du signal d'horloge (2a).

18. Dispositif selon la revendication 16 ou 17,
**caractérisé par le fait que**
l'unité (4) pour la production du signal d'activation (4a) est conçue pour provoquer l'introduction de plusieurs impulsions d'excitation (3c, 3d, 3e, 3f) dans l'oscillateur électromécanique (10).

19. Dispositif selon la revendication 18,
**caractérisé par le fait que**
l'unité (4) pour la production du signal d'activation (4a) est conçue pour provoquer l'introduction périodique de groupes d'impulsions d'excitation (3c, 3d, 3e, 3f) dans l'oscillateur électromécanique (10), chaque groupe (3c, 3d, 3e, 3f) comprenant au moins une impulsion d'excitation (3b).

20. Dispositif selon la revendication 19,
**caractérisé par le fait que**
l'unité (4) pour la production du signal d'activation (4a) est conçue pour, à l'intérieur d'un groupe d'impulsions d'excitation (3c, 3d, 3e, 3f), provoquer l'introduction d'un nombre prédéterminé d'impulsions d'excitation (3b) dans l'oscillateur électromécanique (10), les impulsions d'excitation (3b) des groupes (3c, 3d, 3e, 3f) étant générées à l'aide d'oscillations d'oscillateur (1b, 1c) détectées successives.

21. Dispositif selon la revendication 19 ou 20,
**caractérisé par le fait que**
l'unité (4) pour la production du signal d'activation (4a) est conçue pour faire en sorte que, pendant les intervalles de temps entre la génération des groupes d'impulsions d'excitation (3c, 3d, 3e, 3f), aucune impulsion d'excitation ne soit introduite dans l'oscillateur électromécanique (10).

22. Dispositif selon l'une des revendications 11 à 21,
**caractérisé par le fait que**
l'oscillateur électromécanique (10) comprend un oscillateur piézoélectrique, notamment un oscillateur à quartz.

23. Circuit oscillateur comprenant :
- une unité formant oscillateur (1) avec un oscillateur électromécanique (10), et
- un dispositif selon l'une des revendications 11 à 22.

24. Circuit oscillateur selon la revendication 23,
**caractérisé par le fait que**
l'unité formant oscillateur (1) est conçue comme un oscillateur Colpitts.
